(19) 

Europäisches
Patentamt
European
Patent Office
Office européen
des brevets

(11) **EP 3 806 593 A1**

(12) **EUROPEAN PATENT APPLICATION**
published in accordance with Art. 153(4) EPC

(43) Date of publication:
**14.04.2021 Bulletin 2021/15**

(21) Application number: **19822212.7**

(22) Date of filing: **06.06.2019**

(51) Int Cl.:
*H05K 3/06* (2006.01)      *H01B 13/00* (2006.01)
*H01L 21/312* (2006.01)      *H01L 31/0224* (2006.01)
*H01L 31/0445* (2014.01)

(86) International application number:
**PCT/JP2019/022491**

(87) International publication number:
**WO 2019/244651 (26.12.2019 Gazette 2019/52)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **18.06.2018 JP 2018115189**

(71) Applicant: **KANEKA CORPORATION
Osaka 530-8288 (JP)**

(72) Inventors:
• **TAMAI Hitoshi
  Settsu-shi, Osaka 566-0072 (JP)**
• **TAKAHASHI Yuji
  Settsu-shi, Osaka 566-0072 (JP)**
• **OKAMOTO Shimpei
  Settsu-shi, Osaka 566-0072 (JP)**
• **NAKANO Kunihiro
  Settsu-shi, Osaka 566-0072 (JP)**

(74) Representative: **V.O.
P.O. Box 87930
2508 DH Den Haag (NL)**

(54) **RESIST COMPOSITION FOR PATTERN PRINTING USE, AND METHOD FOR MANUFACTURING CIRCUIT PATTERN USING SAME**

(57) Provided is a resist composition for pattern printing containing a resin (A) component that contains a combination of at least two or more types of amino group-containing resins each containing an amino group of different amine numbers respectively, the entire resin (A) component having an amine number of 1.5 to 10.0, a compound (B) component that generates an amine by means of moisture and/or light, a thickener (C) component, and a diluent (D) component. The resist composition has high resistance to an alkaline etchant, can be easily peeled off by an aqueous acid solution, and enables a protective pattern to be formed by printing.

EP 3 806 593 A1

**Description**

TECHNICAL FIELD

The present invention relates to a resist composition for pattern printing and a method for producing a circuit pattern using the same.

BACKGROUND ART

Resist materials are used as protective materials in forming electrode circuits for semiconductors, plate making, printed circuit boards, etc., and are indispensable for the manufacture of electronic components for home appliance applications, industrial applications, onboard applications and aerospace applications, industrial robots, solar batteries, and the like.

Various properties such as resistance to an etchant for conductive layer and ease in peeling of the resist layer after etching are required for etching resist materials.

In general, in the case of an electrode formation of an electronic substrate or a solar battery electrode, an acid etchant is mostly used for etching a conductive layer, and a resist to be used is a resist of alkali development and peeling type. Incidentally, for solar batteries having a semiconductor and an n-type amorphous photoelectric layer, an etching method using plasma has also been proposed; however, the etching method has problems such as mask accuracy and damages to a base p-layer, and has not been put into practical use. Therefore, it is practical in terms of production to apply a proven wet etching method. Wet etching of the n-layer requires an alkaline etchant. Therefore, an alkaline-resistant resist is essential for its patterning. In addition, from the viewpoint of simplifying the process, in the case of a photosensitive resist, a heat-drying resist for pattern printing is preferred because exposure and development steps are not complicated.

However, as an example of formation of an electrode pattern by alkali etching, there are merely disclosed examples in which in forming a through hole on an FPC, an oxide film of copper is formed at a portion where prevention of etching is desired (Patent Document 1), or a compound which forms an alkali resistant complex with copper is applied (Patent Document 2).

On the other hand, as a resist agent, an alkali-resistant pattern printing resist is not commercially available, and alkali resistance is actually ensured as far as possible by adjusting drying conditions for a resist type having an acid resistance and an alkali peelability through, for example, post-baking or the like (Patent Document 3). Therefore, it is necessary to design a new alkali-resistant resist.

Patent Document 1: JPH02-224295A
Patent Document 2: JPH06-51516A
Patent Document 3: JP3711198B

DISCLOSURE OF THE INVENTION

Problems to be Solved by the Invention

The present invention has been made to solve the above problems, and it is an object of the present invention to provide a resist composition for pattern printing and a method for producing a circuit pattern using the same, which can easily protect a base to be subjected to alkali etching, without a complicated process such as oxidation of a film and complexation, and can allow a protective layer to be quickly peeled off after an etching process.

Means for Solving the Problems

The present inventors have conducted extensive studies to solve the above problems, and have obtained a finding that as a basic design of a resist composition, use of a polymer having a basic functional group such as an amino group as a binder for achieving both alkali resistance and acid peelability and addition of a solvent, a filler, and a thickener imparting thixotropic property thereto exerts favorable effects. Note that the principle of peeling is that an ion pair having a high degree of dissociation is formed between an acid component contained in a peeling solution and a basic residue in the binder component contained in the resist composition, which imparts water solubility to the binder, and thereby allows the resist to be dissolved, swelled and consequently peeled off. It is also conceived that in addition to such a basic design, addition of a component for generating an amine component by a certain type of trigger at the time of peeling as a component for assisting the acid peelability will make it possible to further enhance the accuracy of the peeling control, and that use of a plurality of types of amino group-containing polymers in combination while setting the amine number of the entire binder in a predetermined range will make it possible to achieve a favorable balance of the viscosity, alkali resistance and acid peelability of the resist composition, and further studies have been conducted based on these findings, to accomplish the present invention. More particularly, the present invention provides the following.

Specifically, a first aspect of the present invention for solving the above problems relates to a resist composition for pattern printing, containing a resin (A) component that contains a combination of at least two or more types of amino group-containing resins each containing an amino group of different amine numbers respectively, the entire resin (A) component having an amine number of 1.5 to 10.0, a compound (B) component that generates an amine by means of moisture and/or light, a thickener (C) component, and a diluent (D) component.

In addition, in one embodiment of the first aspect, the resist composition for pattern printing is shown, in which the (A) component includes at least two selected from the group consisting of an amino group-containing acrylic resin and polyethyleneimine.

Further, in one embodiment of the first aspect, the resist composition for pattern printing is also shown, in which the (A) component contains a water-soluble resin and a water-insoluble resin.

In one embodiment of the first aspect, the resist composition for pattern printing is further shown, in which the content of the (A) component is 10 parts by mass or more and 50 parts by mass or less with respect to 100 parts by mass of the resist composition for pattern printing.

In one embodiment of the first aspect, the resist composition for pattern printing is shown, in which the (B) component is at least one selected from the group consisting of a compound having a ketimine structure and a photobase generator, and the content of the (B) component is 0.1 parts by mass or more and 10 parts by mass or less with respect to 100 parts by mass of the resist composition for pattern printing.

In one embodiment of the first aspect, the resist composition for pattern printing is further shown, in which the (C) component is at least one selected from the group consisting of fumed silica, clay, bentonite and talc, and the content of the (C) component is 0.01 parts by mass or more and 5 parts by mass or less with respect to 100 parts by mass of the resist composition for pattern printing.

In a further embodiment of the first aspect, the resist composition for pattern printing is also shown, in which the (D) component is ethylene glycol monoethyl ether.

Another aspect of the present invention for solving the above problems relates to a method for forming a circuit pattern, including etching a base layer with an aqueous alkaline solution using the resist composition for pattern printing according to the first aspect of the present invention.

In one embodiment of the another aspect, the method for forming a circuit pattern is further shown, including, after etching the base layer with an aqueous alkaline solution using the resist composition for pattern printing according to the first aspect of the present invention, peeling off the resist using an aqueous acid solution and/or an alcohol-containing aqueous solution.

Yet another aspect of the present invention for solving the above problems relates to a method for producing a solar battery, including a circuit pattern forming step of forming a circuit pattern on a solar battery amorphous layer according to the method for forming a circuit pattern according to the another aspect of the present invention.

Still another aspect of the present invention for solving the above problems relates to a solar battery which is produced by the method for producing a solar battery according to the yet another aspect of the present invention.

Effects of the Invention

According to the present invention, it is possible to obtain a resist composition which has high resistance to an alkaline etchant, can be easily peeled off with an aqueous acid solution, and enables a protective pattern to be formed by printing.

PREFERRED MODE FOR CARRYING OUT THE INVENTION

One embodiment of the present invention will be described below, but the present invention is not limited thereto.

A resist composition for pattern printing according to the present invention contains a resin (A) component that contains a combination of at least two or more types of amino group-containing resins each containing an amino group of different amine numbers respectively, the entire resin (A) component having an amine number of 1.5 to 10.0, a compound (B) component that generates an amine by means of moisture and/or light, a thickener (C) component, and a diluent (D) component.

Here, the resist composition for pattern printing according to the present invention having the above-described composition is characterized by achieving both alkali etching resistance and acid peelability. As will be described in detail below, the basic performances of the alkali etching resistance and the acid peelability depends on the cationic substituent (amino group) in the resin (A) component. Further, in order to improve the accuracy of the acid peelability while maintaining the alkali etching resistance, the compound (B) component that generates an amine by means of moisture and/or light such as UV (ultraviolet light) serving as a trigger is added. In addition, the thickener (C) is added for the purpose of imparting concealability and thixotropic property which are pattern printing performances, and the viscosity is adjusted by the diluent (D) component. Hereinafter, each component will be described in sequence.

[Resin (A) Component Containing Amino Group]

The resin (A) component to be blended as a binder in the resist composition for pattern printing according to the present invention is a combination of at least two or more types of amino group-containing resins. Moreover, the two or more types of amino group-containing resins to be combined have a different amine number respectively. Then, the amino group-containing resins are combined such that the entire resin (A) component which contains the combination of such a plurality of types of amino group-containing resins has an amine number falling within the range of 1.5 to 10.0, more preferably 1.6 to 7.0, and still more preferably 1.8 to 6.0. Note that the term "amine number" used herein is as measured by acid titration in a non-aqueous system (units: mmol/g (in terms of solid content)), and is expressed as a bare number for simplicity except for a part of the description in the Examples described later.

When the amine number of the entire resin (A) component is less than 1.5, the acid resistance may be increased and favorable acid peelability may not be achieved, and on the other hand, when the amine number exceeds 10.0, the water solubility may become too high, so that the resist pattern may be dissolved and peeled off during alkali etching, resulting in deterioration of the base protective performance.

The amine number of each amino group-containing resin used in combination in the present invention is not particularly limited as long as the amine number of the entire resin (A) component can fall within the above predetermined range when a plurality of these are combined, but typically, for example, various types of amino group-containing resins having an amine number ranging from about 0.5 on the lower side to about 30 on the higher side, which is relatively broad in terms of an amine number, can be used.

Further, the amine number of the entire resin (A) component can be relatively easily adjusted to fall within the desired range by appropriately adjusting the amine number of each of the amino group-containing resins to be combined and the blending amounts thereof. Combining a plurality of types of amino group-containing resins makes it easy to balance the viscosity, the alkali resistance and the acid peelability of the resist composition. For this reason, in addition to the amine number of the entire resin (A) component falling within the desired range, it is desirable that the amount of each of the amino group-containing resins to be combined is substantial to some extent, for example, in the case of combining two types thereof, at least 1 part by mass or more of one amino group-containing resin with respect to 100 parts by mass of the entire resin (A) component is contained, since such an amount allows for enhancement of the improvement of the balance described above. In addition, the number of types of the amino group-containing resins to be combined in constituting the resin (A) component according to the present invention is not limited to 2, and of course, the resin (A) component may be constituted of a combination of more than two, i.e. three or more types of amino group-containing resins. Also when such a larger number of types of amino group-containing resins are combined, it is desired that at least two of them are contained in a substantial blending amount as described above.

The amino group-containing resin which may constitute the resin (A) component according to the present invention, generally, a resin containing an amino group and having an amine number of 0.5 to 30, and desirably 0.6 to 20 as described above, is exemplified by a hydrophilic basic resin which is not crosslinked. Specific examples of such an amino group-containing resin include, but are not limited to, linear polyalkylene amines, branched polyalkylene amines, polyvinylamine, polyallylamine, poly(N-vinylimidazole), polyvinylpyridine, polyvinylpyridine amine oxide, polydiallylamine, polyamidopolyamines, polydimethylaminoalkyl acrylates, polydimethylaminoalkyl methacrylates, polydimethylaminoalkylacrylamides, polydimethylaminoalkylmethacrylamides, polyamidine, polyvinylguanidine, polydiallylamine, poly(acrylic acid hydrazide), aspartic acid-hexamethylenediamine polycondensates; basic polyamino acids such as polylysine; basic resins derived from natural products such as chitosan; and copolymers of these polymers, and the like. Preferably, the basic resin is an amino group-containing basic resin. More preferably, the basic resin is at least one selected from the group consisting of polyethyleneimine, polyallylamine, polyvinylamine, polydiallylamine, and polydiallyldimethylamine, and most preferably, the basic resin is at least one selected from polyethyleneimine, polyallylamine, and polyvinylamine, in which 90 to 100 mol% of the basic groups included in each basic resin is present in the form of an unneutralized (free) base. In addition, in the present invention, the average molecular weight of the basic resin before crosslinking is preferably in the range of about 1000 to 10,000,000.

In addition, in the present invention, preferable examples of the amino group-containing resin used in combination in constituting the resin (A) component include a combination of a water-soluble resin and a water-insoluble resin. The combination of the water-soluble resin and the water-insoluble resin is likely to make both properties of the alkali resistance and the acid peelability favorable. Examples of the water-soluble amino group-containing resin include those as listed above, and on the other hand, the water-insoluble amino group-containing resin is not particularly limited, and specifically, examples thereof include primary amino group-containing acrylic polymers obtained by grafting polyethyleneimine as a side chain (a graft polymer obtained by reacting polyethyleneimine with an acrylic polymer having a carboxyl group), and the like.

The amount of the (A) component to be added is preferably 10 parts by mass or more and 50 parts by mass or less, and more preferably 20 parts by mass or more and 40 parts by mass or less with respect to 100 parts by mass of the resist composition for pattern printing in view of alkali resistance, acid peelability, and printing viscosity.

[Compound (B) that Generates Amines by means of Moisture and/or Light]

As the compound (B) that generates an amine by means of moisture and/or light, which is used in the present invention, any compound which is stable in the absence of moisture and/or light such as ultraviolet light (UV) but which generates an amine upon exposure to the moisture and/or light serving as a trigger can be used.

<Ketimine Compound (B-1)>

Preferable examples of the compound that generates an amine by moisture include a ketimine compound. The ketimine compound (B-1) used in the resist composition for pattern printing according to the present invention is not particularly limited, and various types of ketimine compounds can be used. The ketimine compound (B-1) can be obtained, for example, by a condensation reaction of a known amine compound with a known carbonyl compound. Such a ketimine compound is stably present in the absence of the moisture, and is decomposed into a primary amine and a ketone by moisture, and the resulting primary amine has an effect of accelerating a hydrolytic condensation reaction of a crosslinkable silyl group through a synergistic effect with an organic acid catalyst.

As the ketimine compound (B-1), ketimines listed in, for example, Japanese Unexamined Patent Application, Publication No. H7-242737 and the like may be used. For example, as the amine compound, specifically for example, diamines such as ethylenediamine, propylenediamine, trimethylenedianiline, tetramethylenedianiline, 1,3-diaminobutane, 2,3-diaminobutane, pentamethylenedianiline, 2,4-diaminopentane, hexamethylenediamine, p-phenylenediamine, and p,p'-biphenylenediamine; polyamines such as 1,2,3-triaminopropane, triaminobenzene, tris(2-aminoethyl)amine, tetra(aminomethyl)methane; polyalkylene polyamines such as diethylenetriamine, triethylenetriamine, and tetraethylenepentamine; polyoxyalkylene-based polyamine; aminosilanes such as y-aminopropyltriethoxysilane, y-aminopropyltrimethoxysilane, y-aminopropylmethyldimethoxysilane, y-aminopropylmethyldiethoxysilane, N-(β-aminoethyl)-y-aminopropyltrimethoxysilane, N-(β-aminoethyl)-y-aminopropyltriethoxysilane, and N-(β-aminoethyl)-y-aminopropylmethyldimethoxysilane; and the like may be used. Further, as the carbonyl compound, specifically for example, aldehydes such as acetaldehyde, propionaldehyde, n-butyraldehyde, isobutyraldehyde, diethylacetaldehyde, glyoxal, and benzaldehyde; cyclic ketones such as cyclopentanone, trimethylcyclopentanone, cyclohexanone, and trimethylcyclohexanone; aliphatic ketones such as acetone, methyl ethyl ketone, methyl propyl ketone, methyl isopropyl ketone, methyl isobutyl ketone, diethyl ketone, dipropyl ketone, diisopropyl ketone, dibutyl ketone, and diisobutyl ketone; β-dicarbonyl compound such as acetylacetone, methyl acetoacetate, ethyl acetoacetate, dimethyl malonate, diethyl malonate, methyl ethyl malonate, and dibenzoylmethane; and the like may be used.

In the case where an imino group is present in the ketimine, the imino group may be reacted with styrene oxide; glycidyl ethers such as butyl glycidyl ether, and allyl glycidyl ether; glycidyl esters; and the like.

As these amine components, a silane coupling agent may also be used. Specific examples include ketimine compounds which can be obtained by a reaction of an aminosilane such as y-aminopropyltriethoxysilane, y-aminopropyltrimethoxysilane, y-aminopropylmethyldimethoxysilane, and y-aminopropylmethyldiethoxysilane and a ketone such as methyl ethyl ketone, methyl propyl ketone, methyl isopropyl ketone, and methyl isobutyl ketone. Further examples include N-(1,3-dimethylbutylidene)-3-(triethoxysilyl)-1-propanamine (for example, Sila-Ace S340, manufactured by Chisso Corporation), which is obtained by a reaction of y-aminopropyltriethoxysilane and methyl isobutyl ketone, from the viewpoint of its availability.

Among these, 1,2-ethylenebis(isopentylideneimine), 1,2-hexylenebis(isopentylideneimine), 1,2-propylenebis(isopentylideneimine), p,p'-biphenylenebis(isopentylideneimine), 1,2-ethylenebis(isopropylideneimine), 1,3-propylenebis(isopropylideneimine), p-phenylenebis(isopentylideneimine), and (polycondensates of diethylenetriamine and methyl isobutyl ketone) phenyl glycidyl ether are preferred from the viewpoint of balance of compatibility with the resin component (A) and the amine number.

These ketimine compounds may be used alone or in a combination of two or more thereof. The amount of the ketimine compound to be added is not particularly limited, but is preferably 0.1 parts by mass or more and 10 parts by mass or less, and more preferably 0.5 parts by mass or more and 6 parts by mass or less with respect to 100 parts by mass of the resist composition for pattern printing, in view of curability and storage stability.

<Photobase Generator (B-2)>

Preferable examples of the compound that generates an amine by light (UV) irradiation include a photobase generator.

The photobase generator is not particularly limited, and examples thereof include compounds that generate biguanidium, imidazole, pyridine, diamine and derivatives thereof upon irradiation with light such as ultraviolet radiation, and the like. Among these, compounds that generate imidazole or biguanidium are preferred. Specific examples of the photobase generator are not particularly limited, but include 9-anthrylmethyl N,N-diethylcarbamate, (E)-1-[3-(2-hydroxyphenyl)-2-propenoyl]piperidine, 1-(anthraquinon-2-yl)ethyl imidazolecarboxylate, 2-nitrophenylmethyl 4-methacryloyloxypiperidine-1-carboxylate, 1,2-diisopropyl-3-[bis(dimethylamino)methylene]guanidium 2-(3-benzoylphenyl)propionate, 1,2-dicyclohexyl-4,4,5,5-tetramethylbiguanidium n-butyltriphenylborate, and the like. These photobase generators may be used either alone of one type or in a combination of two or more types thereof.

The amount of addition of the photobase generator is preferably 0.1 parts by mass or more and 10 parts by mass or less, and more preferably 0.5 parts by mass or more and 6 parts by mass or less, with respect to 100 parts by mass of the resist composition for pattern printing.

[Thickener (C)]

The thickener is an essential component in terms of imparting thixotropic property to a resist for pattern printing. The thickener is not particularly limited as long as it can be generally blended in a resist composition, and examples thereof include barium carbonate, calcium carbonate, mica, fumed silica, talc, clay, bentonite, barium sulfate, amide waxes, polyvinylpyrrolidone, acrylic polymers, polyolefin waxes, urea derivatives, nonionic hydrophobically-modified polymers, castor oil derivatives, alkylallylsulfonic acid salts, alkylammonium salts, polyethylene linear fiber, and the like. When the thickener as exemplified hereinabove is in the form of a powder, the thickener is desirably, but is not particularly limited to, in the form of so-called nanoparticles having a primary particle diameter of less than 1 $\mu$m, typically about 20 nm to less than 1000 nm, and more preferably about 50 nm to 500 nm from the viewpoint of the function as the thickener to impart the thixotropic property. In addition, among the thickeners exemplified above, calcium carbonate, mica, fumed silica, talc, clay, bentonite, barium sulfate, amide waxes, polyvinylpyrrolidone, polyolefin waxes, oxidized polyolefins, urea derivatives, nonionic hydrophobically-modified polymers, castor oil derivatives, alkylallylsulfonic acid salts, alkylammonium salts, polyethylene linear fiber, and the like are preferred in terms of balance of impartment of the thixotropic property and dispersibility in the resist composition as well as alkali resistance. Fumed silica, talc, clay, and bentonite are more preferred in that a small amount of them can impart the thixotropic property to the resist composition for pattern printing in a small amount. Fumed silica is produced by a dry process, and is more preferred in that the density of the thickener can be controlled.

The amount of addition of the thickener (C) is preferably 0.01 parts by mass or more and 5 parts by mass or less, and more preferably 0.1 parts by mass or more and 2 parts by mass or less, with respect to 100 parts by mass of the resist composition for pattern printing.

[Diluent (D) Component]

The diluent is not particularly limited as long as it exhibits favorable solubility in the (A) component and the (B) component, as well as favorable dispersibility of the (C) component, is rapidly dried by heating without excessively drying at the time of printing, and does not cause defects such as bubbles in the resist pattern.

Specific examples include cycloalkyl alcohol, cycloalkyl acetate, alkylene glycol, alkylene glycol diacetate, alkylene glycol monoether, alkylene glycol dialkyl ether, alkylene glycol monoether acetate, dialkylene glycol monoether, dialkylene glycol dialkyl ether, dialkylene glycol monoalkyl ether acetate, trialkylene glycol monoether, trialkylene glycol monoether acetate, 3-methoxybutanol, 3-methoxybutanol acetate, tetrahydrofurfuryl alcohol, tetrahydrofurfuryl alcohol acetate, terpene-based compounds and derivatives thereof, and the like.

Examples of the cycloalkyl alcohol include cycloalkyl alcohols having 3 to 15 ring atoms and optionally being substituted with a $C_{1-5}$ alkyl group and the like, such as cyclopentanol, cyclohexanol, cyclooctyl alcohol, methylcyclohexyl alcohol, ethylcyclohexyl alcohol, propylcyclohexyl alcohol, i-propylcyclohexyl alcohol, butylcyclohexyl alcohol, i-butylcyclohexyl alcohol, s-butylcyclohexyl alcohol, t-butylcyclohexyl alcohol, and pentylcyclohexyl alcohol, and the like.

Examples of the cycloalkyl acetate include cycloalkyl acetates having 3 to 15 ring atoms and optionally being substituted with a $C_{1-5}$ alkyl group and the like, such as cyclohexyl acetate, cyclopentyl acetate, cyclooctyl acetate, methylcyclohexyl acetate, ethylcyclohexyl acetate, propylcyclohexyl acetate, i-propylcyclohexyl acetate, butylcyclohexyl acetate, i-butylcyclohexyl acetate, s-butylcyclohexyl acetate, t-butylcyclohexyl acetate, and pentylcyclohexyl acetate, and the like.

Examples of the alkylene glycol include ethylene glycol, propylene glycol, 1,3-propanediol, 1,3-butylene glycol, 1,4-butanediol, 1,5-pentanediol, 1,6-hexanediol, and the like.

Examples of the alkylene glycol diacetate include ethylene glycol diacetate, propylene glycol diacetate, 1,3-propanediol diacetate, 1,3-butylene glycol diacetate, 1,4-butanediol diacetate, 1,5-pentanediol diacetate, 1,6-hexanediol diacetate, and the like.

Examples of the alkylene glycol monoether include: ethylene glycol mono $C_{1-5}$ alkyl ethers such as ethylene glycol monomethyl ether, ethylene glycol monoethyl ether, ethylene glycol monopropyl ether, ethylene glycol monobutyl ether, and ethylene glycol monopentyl ether; propylene glycol mono $C_{1-5}$ alkyl ethers such as propylene glycol monomethyl ether, propylene glycol monoethyl ether, propylene glycol monopropyl ether, propylene glycol monobutyl ether, and propylene glycol monopentyl ether, and the like.

Examples of the alkylene glycol dialkyl ether include: ethylene glycol $C_{1-5}$ alkyl (linear or branched) $C_{1-5}$ alkyl (linear or branched) ethers (terminal alkyl groups being symmetric) such as ethylene glycol dimethyl ether, ethylene glycol diethyl ether, ethylene glycol dipropyl ether, ethylene glycol dibutyl ether, and ethylene glycol dipentyl ether; ethylene glycol $C_{1-5}$ alkyl (linear or branched) $C_{1-5}$ alkyl (linear or branched) ethers (terminal alkyl groups being asymmetric) such as ethylene glycol ethyl methyl ether, ethylene glycol methyl propyl ether, ethylene glycol butyl methyl ether, ethylene glycol methyl pentyl ether, ethylene glycol ethyl propyl ether, ethylene glycol butyl ethyl ether, ethylene glycol ethyl pentyl ether, ethylene glycol butyl propyl ether, ethylene glycol propyl pentyl ether, and ethylene glycol butyl pentyl ether; propylene glycol $C_{1-5}$ alkyl (linear or branched) $C_{1-5}$ alkyl (linear or branched) ethers (terminal alkyl groups being symmetric) such as propylene glycol dimethyl ether, propylene glycol diethyl ether, propylene glycol dipropyl ether, propylene glycol dibutyl ether, and propylene glycol dipentyl ether; propylene glycol $C_{1-5}$ alkyl (linear or branched) $C_{1-5}$ alkyl (linear or branched) ethers (terminal alkyl groups being asymmetric) such as propylene glycol ethyl methyl ether, propylene glycol methyl propyl ether, propylene glycol butyl methyl ether, propylene glycol methyl pentyl ether, propylene glycol ethyl propyl ether, propylene glycol butyl ethyl ether, propylene glycol ethyl pentyl ether, propylene glycol butyl propyl ether, propylene glycol propyl pentyl ether, and propylene glycol butyl pentyl ether; and the like.

Examples of the alkylene glycol monoalkyl ether acetate include: ethylene glycol mono $C_{1-5}$ alkyl ether acetates such as ethylene glycol monomethyl ether acetate, ethylene glycol monoethyl ether acetate, ethylene glycol monopropyl ether acetate, ethylene glycol monobutyl ether acetate, and ethylene glycol monopentyl ether acetate; propylene glycol mono $C_{1-5}$ alkyl ether acetates such as propylene glycol monoethyl ether acetate, propylene glycol monopropyl ether acetate, propylene glycol monobutyl ether acetate, and propylene glycol monopentyl ether acetate; and the like (including isomers thereof).

Examples of the dialkylene glycol monoether include: diethylene glycol mono $C_{1-5}$ alkyl ethers such as diethylene glycol monomethyl ether, diethylene glycol monoethyl ether, diethylene glycol monopropyl ether, diethylene glycol monobutyl ether, and diethylene glycol monopentyl ether; dipropylene glycol mono $C_{1-5}$ alkyl ethers such as dipropylene glycol monomethyl ether, dipropylene glycol monoethyl ether, dipropylene glycol monopropyl ether, dipropylene glycol monobutyl ether, and dipropylene glycol monopentyl ether; and the like (including isomers thereof).

Examples of the dialkylene glycol dialkyl ether include: diethylene glycol $C_{1-5}$ alkyl (linear or branched) $C_{1-5}$ alkyl (linear or branched) ethers (terminal alkyl groups being symmetric) such as diethylene glycol dimethyl ether, diethylene glycol diethyl ether, diethylene glycol dipropyl ether, diethylene glycol dibutyl ether, and diethylene glycol dipentyl ether; diethylene glycol $C_{1-5}$ alkyl (linear or branched) $C_{1-5}$ alkyl (linear or branched) ethers (terminal alkyl groups being asymmetric) such as diethylene glycol ethyl methyl ether, diethylene glycol methyl propyl ether, diethylene glycol butyl methyl ether, diethylene glycol methyl pentyl ether, diethylene glycol ethyl propyl ether, diethylene glycol butyl ethyl ether, diethylene glycol ethyl pentyl ether, diethylene glycol butyl propyl ether, diethylene glycol propyl pentyl ether, and diethylene glycol butyl pentyl ether; dipropylene glycol $C_{1-5}$ alkyl (linear or branched) $C_{1-5}$ alkyl (linear or branched) ethers (terminal alkyl groups being symmetric) such as dipropylene glycol dimethyl ether, dipropylene glycol diethyl ether, dipropylene glycol dipropyl ether, dipropylene glycol dibutyl ether, and dipropylene glycol dipentyl ether; dipropylene glycol $C_{1-5}$ alkyl (linear or branched) $C_{1-5}$ alkyl (linear or branched) ethers (terminal alkyl groups being asymmetric) such as dipropylene glycol ethyl methyl ether, dipropylene glycol methyl propyl ether, dipropylene glycol butyl methyl ether, dipropylene glycol methyl pentyl ether, dipropylene glycol ethyl propyl ether, propylene glycol butyl ethyl ether, dipropylene glycol ethyl pentyl ether, dipropylene glycol butyl propyl ether, dipropylene glycol butyl propyl ether, and dipropylene glycol propyl pentyl ether; and the like (including isomers thereof).

Examples of the dialkylene glycol monoalkyl ether acetate include: diethylene glycol mono $C_{1-5}$ alkyl ether acetates such as diethylene glycol monomethyl ether acetate, diethylene glycol monopropyl ether acetate, diethylene glycol monobutyl ether acetate, and diethylene glycol monopentyl ether acetate; dipropylene glycol mono $C_{1-5}$ alkyl ether acetates such as dipropylene glycol monoethyl ether acetate, dipropylene glycol monopropyl ether acetate, dipropylene glycol monobutyl ether acetate, and dipropylene glycol monopentyl ether acetate; and the like (including isomers thereof).

Examples of the trialkylene glycol monoether include: triethylene glycol mono $C_{1-5}$ alkyl ethers such as triethylene glycol monomethyl ether, triethylene glycol monoethyl ether, triethylene glycol monopropyl ether, triethylene glycol monobutyl ether, and triethylene glycol monopentyl ether; tripropylene glycol mono $C_{1-5}$ alkyl ethers such as tripropylene glycol monomethyl ether, tripropylene glycol monoethyl ether, tripropylene glycol monopropyl ether, tripropylene glycol monobutyl ether, and tripropylene glycol monopentyl ether; and the like (including isomers thereof).

Examples of the trialkylene glycol monoether acetate include: triethylene glycol mono $C_{1-5}$ alkyl ether acetates such as triethylene glycol monomethyl ether acetate, triethylene glycol monoethyl ether acetate, triethylene glycol monopropyl ether acetate, triethylene glycol monobutyl ether acetate, and triethylene glycol monopentyl ether acetate; tripropylene glycol mono $C_{1-5}$ alkyl ether acetates such as tripropylene glycol monomethyl ether acetate, tripropylene glycol monoethyl ether acetate, tripropylene glycol monopropyl ether acetate, tripropylene glycol monobutyl ether acetate, and tripropylene glycol monopentyl ether acetate; and the like (including isomers thereof).

Examples of the terpene-based compounds and derivatives thereof include terpineol, terpineol acetate, dihydroterpineol, dihydroterpinyl acetate, dihydroterpinyl propionate, limonene, menthane, menthol, and the like.

Among others, ethylene glycol monoalkyl ethers are preferred in terms of binder solubility, dispersibility of the thickener, moderate volatility, and viscosity control. Further, the amount of the solvent (D) component to be added is preferably 1 part by mass or more and 100 parts by mass or less, and more preferably 5 parts by mass or more and 80 parts by mass or less, with respect to 100 parts by mass of the resist composition for pattern printing.

<Leveling Agent>

A leveling agent may be added to the resist composition for pattern printing in order to adjust the surface irregularities when cured.

Generally, examples of the leveling agent include fluorine-based leveling agents, silicone-based leveling agents, acrylic leveling agents, ether-based leveling agents, and ester-based leveling agents, and any of these leveling agents may be used in the resist composition for pattern printing according to the present invention.

<Antifoaming Agent>

An antifoaming agent may be added to the resist composition for pattern printing for the purpose of preventing generation of bubbles which may be generated in screen printing or the like. Preferred examples include acrylic antifoaming agents, silicon-based antifoaming agents, and fluorine-based antifoaming agents.

<Adhesiveness Imparting Agent>

An adhesiveness imparting agent may be added to the resist composition for pattern printing in order to improve adhesion to the base material.

As the adhesiveness imparting agent, a crosslinkable silyl group-containing compound and a vinyl monomer having a polar group are preferred, and further, a silane coupling agent and an acidic group-containing vinyl monomer are preferred.

As the silane coupling agent, for example, a silane coupling agent having both a functional group having, in the molecule thereof, an atom other than a carbon atom and a hydrogen atom, such as an epoxy group, an isocyanate group, an isocyanurate group, a carbamate group, an amino group, a mercapto group, a carboxyl group, a halogen group, and a (meth)acryl group, and a cross-linkable silyl group may be used.

<Filler>

A filler may be added to the resist composition for pattern printing in order to ensure a certain level of strength. Here, the filler is not particularly limited, but is desirably a filler having a primary particle diameter of 1 pm or more, typically about 1 pm to 50 pm, and more preferably about 5 pm to 20 pm, from the viewpoint of the function as a filler to impart strength to a resist.

The filler is not particularly limited, but crystalline silica, fused silica, dolomite, carbon black, titanium oxide, and the like are preferred from the viewpoint of their ability to improve the filling ratio through addition of a small amount thereof. In particular, when it is desired to obtain a cured product having high strength with these fillers, a filler material mainly selected from crystalline silica, fused silica, anhydrous silicic acid, hydrous silicic acid, carbon black, surface-treated fine calcium carbonate, activated zinc white, and the like is preferred.

<Plasticizer>

A plasticizer may be added to the resist composition for pattern printing in order to adjust viscosity, slump property, or mechanical properties such as hardness, tensile strength, or elongation when cured.

Examples of the plasticizer include:

phthalic acid ester compounds such as dibutyl phthalate, diisononyl phthalate (DINP), diheptyl phthalate, di(2-ethylhexyl) phthalate, diisodecyl phthalate (DIDP), and butyl benzyl phthalate;
terephthalic acid ester compounds such as bis(2-ethylhexyl) 1,4-benzenedicarboxylate (for example, EASTMAN 168 (manufactured by EASTMAN CHEMICAL));

non-phthalic acid ester compounds such as 1,2-cyclohexanedicarboxylic acid diisononyl ester (for example, Hexamoll DINCH (manufactured by BASF)); aliphatic polyhydric carboxylic acid ester compounds such as dioctyl adipate, dioctyl sebacate, dibutyl sebacate, diisodecyl succinate, and tributyl acetylcitrate;

unsaturated fatty acid ester compounds such as butyl oleate, and methyl acetylricinoleate;

alkylsulfonic acid phenyl esters (for example, Mesamoll (manufactured by LANXESS));

phosphoric acid ester compounds such as tricresyl phosphate, and tributyl phosphate;

trimellitic acid ester compounds;

chlorinated paraffins;

hydrocarbon-based oils such as alkyldiphenyl, and partially hydrogenated terphenyl;

process oils;

epoxy plasticizers such as epoxidized soybean oils, and epoxy benzyl stearate; and the like.

[Method for Producing Resist Composition for Pattern Printing]

The resist composition for pattern printing is produced by mixing and stirring the resin (A) containing an amino group and having an amine number of 1.5 to 4.0, the compound (B) that generates an amine by means of moisture and/or light, the thickener (C) component, and the diluent (D) component in this order. In the production, sufficient stirring and kneading after the addition of the (C) component enables a resist composition for pattern printing with imparted thixotropic property to be effectively obtained. In addition, since the (B) component is affected by moisture contamination, the (B) component is desirably added slightly more than the designed amount in consideration of moisture in the system.

Examples of the apparatus used for kneading include a stirring and defoaming apparatus such as a three-roll mill, a planetary mixer, and a planetary stirring and defoaming apparatus. Note that the apparatus can be used in a combination of a plurality of types thereof.

Incidentally, when kneading, attention should be paid such that volatilization of the solvent component due to heat generation during kneading is avoided. The temperature during the kneading is preferably 0°C or higher and 80°C or lower, more preferably 5°C or higher and 60°C or lower, and still more preferably 10°C or higher and 50°C or lower from the viewpoint of balance between stability and the kneading of (C) component and the filler added additionally.

Further, it is also possible to obtain a resist composition for pattern printing according to the present invention by mixing and kneading the (D) component into a resist composition for pattern printing in which the (A) component, the (B) component, and the (C) component are mixed beforehand. In this case, the kneading method is the same as described above.

[Properties of Resist Composition for Pattern Printing]

The resist composition for pattern printing according to the present invention can be used for etching and patterning, for example, a conductive layer of a device such as an electrode film, an electrode substrate or a solar battery, as described above. For example, in the case of FPD, the resist composition for pattern printing is used for circuit-forming (etching) of an ITO (Indium Tin Oxide) film and FPC (Flexible Printed Circuits) made of polyimide. Further, in the case of a solar battery, the resist composition for pattern printing according to the present invention can be used to form a photoelectron generating and transferring layer beneath a collecting electrode on a silicon substrate, and an amorphous layer pattern only on one main surface of a silicon substrate, in particular, in a back electrode type solar battery.

[Method for Producing Circuit Pattern]

The method for producing a circuit pattern according to the present invention includes a step of etching an amorphous silicon layer with an aqueous alkaline solution using, as a mask, a resist pattern formed on the amorphous silicon layer using the resist composition for pattern printing according to the present invention. The method for producing a circuit pattern may further include a step of, after etching the amorphous silicon layer with the aqueous alkaline solution, peeling off the resist using an aqueous acid solution such as hydrochloric acid, sulfuric acid, or nitric acid and/or an alcohol-containing aqueous solution that does not produce a flash point. The pH of the aqueous alkaline solution may range from 8.0 to 13.0, or 8.5 to 12.0. The pH of the aqueous acid solution may range from 0.1 to 5.0, or 0.3 to 4.0. Examples of the alcohol in the alcohol-containing aqueous solution include isopropanol, n-butanol, 2-butanol, isobutanol, hexanol, cyclohexanol, n-octanol, 2-ethyl-hexyl alcohol, n-decanol, 1-(2-methoxy-2-methoxyethoxy)-2-propanol, 3-methoxy-3-methylbutanol, 1-methoxy-2-propanol, 1-ethoxy-2-propanol, benzyl alcohol, and the like.

Since the resist composition for pattern printing according to the present invention enables a resist pattern to be formed by printing, a favorable resist pattern can be easily formed on a base layer through printing such as screen printing. Further, since the resist composition for pattern printing according to the present invention has high resistance to an alkali-based etchant, a favorable resist pattern is likely to be maintained when the amorphous silicon layer is etched by an aqueous alkaline solution, which makes it easier to accurately obtain a desired circuit pattern. Further, since the resist composition for pattern printing according to the present invention can be easily peeled off by a weak aqueous acid solution, a residue hardly remains on the resultant circuit pattern, and an electronic substrate, a solar battery electrode, or the like having high electrical performance such as electrode performances can be easily obtained.

[Solar Battery]

The solar battery according to the present invention includes a circuit pattern obtained using the resist composition for pattern printing according to the present invention or the method for producing a circuit pattern according to the present invention. As described above, since a residue hardly remains on this circuit pattern, a solar battery electrode having high electrode performances is likely to be obtained from this circuit pattern. As a result, the solar battery according to the present invention is likely to exhibit a high conversion efficiency.

The present invention is not limited to the above-described embodiments, and various modifications can be made within the scope defined in the claims. In other words, embodiments obtained by combining technical means appropriately modified within the scope defined in the claims are also included in the technical scope of the present invention.

As described above, the resist composition for pattern printing according to the present invention is "a resist composition for pattern printing containing the resin (A) that contains a combination of at least two or more amino group-containing resins each containing an amino group of different amine numbers respectively, the entire resin (A) having an amine number of 1.5 to 10.0, the compound (B) component that generates an amine by means of moisture and/or light, the thickener (C) component, and the diluent (D) component", and each of the properties described in the above description and the following Examples in the specification of the present application can be analyzed by the following measurement methods.

<Amine Number>

As described above, the amine number is measured by acid titration in a non-aqueous system. More particularly, the amine number is measured in accordance with the method described in ASTM D2074 using the following procedure:

(1) a sample in an amount of 0.5 to 2 g is precisely weighed;
(2) the sample is dissolved in 30 ml of neutral ethanol; and
(3) titration is performed with 0.2 mol/1 ethanolic hydrochloric acid solution. The amine number is calculated using the titration amount and the following formula:

$$\text{Amine number} = (\text{titration amount} \times \text{titer of titrant} \times 0.2 \times 56.108)/\text{sample mass}$$

<Performance Evaluation of Resist Composition for Pattern Printing>

The performances of the resist composition for pattern printing of the present invention are evaluated by the following methods.

(Viscosity)

Viscosity is measured using a B-type viscometer as described in JIS Z 8803. Especially, since the conductive paste composition according to the present invention is highly viscous, the viscosity can be measured with HB type (manufactured by EKO Instruments Co. Ltd.). The viscosity measured at 23 ± 1°C using a spindle SC4-14 as a rotor is defined as the viscosity specified herein.

(Printability)

A pattern is printed on a silicon wafer on which an amorphous layer was formed, using a screen printing plate with a L/S of 750/250 pm and an emulsion thickness of 20 pm, and a screen printing machine at a squeegee pressure of 0.20 MPa and a speed of 100 mm/min, and the spread of the pattern width with respect to the design value, the height, and the seepage width from the end of the resist pattern due to the (A) component dissolved in the (D) component are measured and evaluated.

(Alkaline Etchant Resistance)

A resist with a line width of 450 pm, an interline space of 100 pm, and a thickness of 40 pm was screen-printed on a cell in which an n-layer (hole) was formed on a textured silicon wafer having a p-layer pattern formed, and dried at 120°C for 30 minutes to form a resist pattern. In addition, for systems containing a photobase generator as the (B) component, a resist pattern was formed by UV irradiation (UV irradiation device: Light Hammer-6 (conveyor type), manufactured by Heraeus) at an integrated light amount of 1,000 mJ/cm$^2$ after drying. After immersion in a 4% by mass aqueous potassium hydroxide solution contained in an etching tank for 10 minutes, the state of the n-layer is inspected by a scanning microscope (SEM), and the alkaline etchant resistance is evaluated according to the following evaluation criteria:

Favorable: the pattern width of the n-layer being 400 pm or more and 450 pm or less;
Acceptable: the pattern width of the n-layer being 350 pm or more and less than 400 pm; and
Poor: the pattern width of the n-layer being less than 350 pm.

(Resist Peelability)

The sample subjected to the alkali etching described above is immersed in a 3% by mass aqueous hydrochloric acid solution for 10 minutes with shaking (shaking stroke = 3 cm), and thereafter the state of resist peeling is observed with an optical microscope.

EXAMPLES

Hereinafter, the present invention will be specifically described by way of Examples, but the present invention is not limited by these Examples.

<Preparation of Resist Composition for Pattern Printing (See Table 1 for Composition)>

[Example 1]

Predetermined amounts of the following materials, i.e., (A) component, (B) component, and fumed silica among (C) component were added to a vessel ($\varphi$89 × $\varphi$98 × 94 mm, internal volume of 470 cc, made of polypropylene) dedicated to blending, and hand-stirred with a medicine spoon. A predetermined amount of (D) component was added to the resultant mixture, and the mixture was also premixed with a medicine spoon, and further, a predetermined amount of hydrous magnesium silicate (talc) as a filler among the (C) components was added. After mixing with a medicine spoon, the mixture was subjected to shearing and stirring using a dedicated stirring and defoaming apparatus (product number: Thinky mixer ARV-310, manufactured by Thinky Corporation). Then, defoaming was performed to obtain a resist composition for pattern printing. The properties including viscosity, printability, alkaline etchant resistance, and resist peelability were evaluated on the resist composition for pattern printing obtained thus, according to the above-described measurement methods. The results obtained are shown in Table 1.

<Resin (A) Component>

•   NK-100PM (water-soluble amine-modified acrylic resin, manufactured by Nippon Shokubai Co., Ltd.): 48 g

* Physical properties of resin

Nonvolatile components = 50% by weight, glass-transition temperature = 13°C, mass-average molecular weight = 20,000, amine number = 2.6 mmol/g (in terms of solid content), solvent component = propylene glycol monomethyl ether, viscosity = 6 Pa·s.

•   NK-350 (water-insoluble amine-modified acrylic resin, manufactured by Nippon Shokubai Co., Ltd.); 10 g

* Physical properties of resin

Nonvolatile component = 35% by mass, glass transition temperature = 40°C, mass-average molecular weight = 100,000, amine number = 0.8 mmol/g (in terms of solid content), toluene/isopropyl alcohol = 45% by mass/20% by mass, and viscosity = 1 Pa·s.

- Amine number of the entire resin (A) component: 2.29

<(B) Component>

- EH-235R-2 (manufactured by ADEKA Corporation): 3 g
  (Viscosity = 17 mPa·s, amine number = 289 mmol/g)

<Thickener (C) Component>

- AEROSIL #300 (hydrophilic fumed silica, manufactured by Evonik Japan Co., Ltd.)
  : 2 g
- Hydrous magnesium silicate (manufactured by Wako Pure Chemical Industries, Ltd.): 27 g

<Diluent (D) Component>

- Ethylene glycol monoethyl ether (manufactured by Wako Pure Chemical Industries, Ltd.): 10 g

[Example 2]

A resist composition for pattern printing was prepared in the same manner as in Example 1, except that the (A) component of Example 2 was composed of 38 g of NK-100PM and 20 g of NK-350, as shown in Table 1. Note that in the resist composition for pattern printing of Example 2, the amine number of the entire resin (A) component was 1.98. The same characterization as in Example 1 was performed on the resist composition for pattern printing obtained thus. The results obtained are shown in Table 1.

[Example 3]

A resist composition for pattern printing was prepared in the same manner as in Example 1, except that WPBG-266 (1,2-diisopropyl-3-[bis(dimethylamino)methylene]guanidinium 2-(3-benzophenyl)propionate, manufactured by Wako Pure Chemical Industries, Ltd.) was used as a photobase generator instead of the ketimine compound of the (B) component of Example 1, as shown in Table 1. Note that in the resist composition for pattern printing of Example 3, the amine number of the entire resin (A) component was 2.29. The same characterization as in Example 1 was performed on the resist composition for pattern printing obtained thus. The results obtained are shown in Table 1. The same characterization was performed. The results obtained are shown in Table 1.

[Example 4]

A resist composition for pattern printing was prepared in the same manner as in Example 1, except that NK-200PM was used instead of NK-100PM of Example 1. Note that in the resist composition for pattern printing of Example 4, the amine number of the entire resin (A) component was 2.29. The same characterization as in Example 1 was performed on the resist composition for pattern printing obtained thus. The results obtained are shown in Table 1. The same characterization was performed. The results obtained are shown in Table 1.

- NK-200PM (water-soluble amine-modified acrylic resin, manufactured by Nippon Shokubai Co., Ltd.)

\* Physical properties of resin

Nonvolatile components = 55% by weight, glass-transition temperature = 16°C, mass-average molecular weight = 20,000, amine number = 2.6 mmol/g (in terms of solid content), solvent component = propylene glycol monomethyl ether, viscosity = 30 Pa ·s.

[Example 5]

A resist composition for pattern printing was prepared in the same manner as in Example 4, except that the amount of NK-200PM as the (A) component was set to 40 g and 18 g of EPOMIN SP-006 was additionally blended. Note that in the resist composition for pattern printing of Example 5, the amine number of the entire resin (A) component was 8.0. The same characterization as in Example 1 was performed on the resist composition for pattern printing obtained thus. The results obtained are shown in Table 1. The same characterization was performed. The results obtained are shown in Table 1.

- EPOMIN SP-006 (polyethyleneimine, manufactured by Nippon Shokubai Co., Ltd.)

\* Physical properties of resin

Nonvolatile component = 98%, molecular weight = 600, amine number = 20 mmol/g (in terms of solid content), viscosity = 1.5 Pa s.

[Example 6]

A resist composition for pattern printing was prepared in the same manner as in Example 1, except that the amount of NK-100PM in the resin (A) component in Example 1 was changed to 23 g, the amount of NK-350 in the resin (A) component in Example 1 was changed to 23 g, and 12 g of EPOMIN SP-200 was further added. Note that in the resist composition for pattern printing of Example 6, the amine number of the entire resin (A) component was 5.28. The same characterization as in Example 1 was performed on the resist composition for pattern printing obtained thus. The results obtained are shown in Table 1.

- EPOMIN SP-200 (polyethyleneimine, manufactured by Nippon Shokubai Co., Ltd.)

\* Physical properties of resin

Non-volatile component = 98%, molecular weight = 10,000, amine number =19 mmol/g (in terms of solid content), viscosity = 95 Pa -s.

[Comparative Example 1]

A resist composition for pattern printing was prepared in the same manner as in Example 1, except that all of NK-100PM of the components (A) in Example 1 were replaced with NK-350. Note that in the resist composition for pattern printing of Comparative Example 1, the amine number of the entire resin (A) component was 0.8. The same characterization was performed. The results obtained are shown in Table 1.

[Comparative Example 2]

A resist composition for pattern printing was prepared in the same manner as in Comparative Example 1, except that the ketimine compound (B) component EH-235R-2 in Comparative Example 1 was not blended and the amount of the (D) component ethylene glycol monoethyl ether was changed to 13 g, and the same characterization was performed. Note that in the resist composition for pattern printing of Comparative Example 2, the amine number of the entire resin (A) component was 0.8. The results obtained are shown in Table 1.

(Printability)

As apparent from the results shown in Table 1, all of the resist compositions for pattern printing of Examples 1 to 6 and Comparative Examples 1 and 2 exhibited favorable screen printability.

(Alkaline Etchant Resistance)

As apparent from the results shown in Table 1, there was no difference in alkaline etchant resistance to a 4% by mass aqueous alkaline solution, which is an etchant, between Comparative Examples 1 and 2 and Examples 1 to 6, and the results were very favorable.

(Resist Peelability)

As apparent from the results shown in Table 1, in the evaluation of the peelability with regard to 3% by mass of hydrochloric acid, the resists in Comparative Examples 1 and 2 were not peeled off at all even after immersion for 10 minutes, whereas in Examples 1 to 6, the peeling was completed without leaving any residue by immersion for 10 minutes and subsequent rinsing with pure water, and the results were favorable.

[Table 1]

| | Classification | Class | Product name, compound | Example 1 | Example 2 | Example 3 | Example 4 | Example 5 | Example 6 | Comparative Example 1 | Comparative Example 2 |
|---|---|---|---|---|---|---|---|---|---|---|---|
| Composition recipe(unit: parts by mass) | (A) Component | Amine-modified acrylic resin solution | NK-100PM (Nonvolatile components = 50%, amine number = 2.6[1]*, solvent PM[2]*) | 48 | 38 | 48 | | | 23 | | |
| | | | NK-350 (Nonvolatile components = 35%, amine number = 0.8, solvent TOL/IPA[3]* = 7/3) | 10 | 20 | 10 | 10 | | 23 | 58 | 58 |
| | | | NK-200PM (Nonvolatile components = 55%, amine number = 2.6, solvent PM) | | | | 48 | 40 | | | |
| | | Polyethyleneimine | EPOMIN SP-006(Nonvolatile components = 98%, amine number = 20) | | | | | 18 | | | |
| | | | EPOMIN SP-200(Nonvolatile components = 98%, amine number = 19) | | | | | | 12 | | |
| | (B) Component | Ketimine compound | EH-235R-2 | 3 | 3 | | 3 | 3 | 3 | 3 | |
| | | Photobase generator | WPBG-266 | | | 3 | | | | | |

(continued)

| | Classification | Class | Product name, compound | Example 1 | Example 2 | Example 3 | Example 4 | Example 5 | Example 6 | Comparative Example 1 | Comparative Example 2 |
|---|---|---|---|---|---|---|---|---|---|---|---|
| | (C)Component | Thickener | AEROSIL#300 (fumed silica) | 2 | 2 | 2 | 2 | 2 | 2 | 2 | 2 |
| | | | Hydrous magnesium silicate (talc) | 27 | 27 | 27 | 27 | 27 | 27 | 27 | 27 |
| | (D) Component | Diluent | Ethylene glycol monoethyl ether | 10 | 10 | 10 | 10 | 10 | 10 | 10 | 13 |
| Parameter | Amine number of entire (A) component | | | 2.29 | 1.98 | 2.29 | 2.29 | 8 | 5.28 | 0.8 | 0.8 |
| Physical properties | Viscosity of formulation 4)* (Viscosity measured using B-type viscometer at 5 rpm(Pas))4)* | | | 44 | 54 | 44 | 234 | 162 | 104 | 35 | 32 |
| | Printability | Pattern spreadability | Pattern spread width/design pattern width (μm) | 90/800 | 100/800 | 80/800 | 80/800 | 120/800 | 100/800 | 100/800 | 100/800 |
| | Alkaline Etchant Resistance | | Resistance to 4% aqueous potassium hydroxide solution (immersion for 10 min) | Favorable | Favorable | Favorable | Favorable | Acceptable | Acceptable | Favorable | Favorable |
| | Resist Peelability | | 3% hydrochloric acid | No problem(complete peeling without residue) | | | | | | 10 min residue remaining | |
| 1)* Unit of amine number=mmol/g (in terms of solid content) 2)* PM: propylene glycol monomethyl ether 3)* TOL: toluene/IPA: isopropyl alcohol 4)* Measurement device = BROOK FIELD DVIM type(manufactured by EKO Instruments Co. Ltd.), rotor = spindle SC4-14, measurement temperature = 23°C | | | | | | | | | | | |

[General Evaluation]

In Examples 1 to 6 concerning the resist composition for pattern printing according to the present invention, containing the resin (A) that contains a combination of at least two or more types of amino group-containing resins each containing an amino group of different amine numbers respectively, the entire resin (A) having an amine number of 1.5 to 10.0, the compound (B) that generates an amine by means of moisture and/or light, the thickener (C) component, and the diluent (D) component, the peelability by an aqueous acid solution is remarkably improved as compared with Comparative Examples 1 to 2, while the printability and the etchant resistance, which are the basic performances of the resist, are maintained.

**Claims**

1. A resist composition for pattern printing, comprising a resin (A) component that comprises a combination of at least two or more types of amino group-containing resins each comprising an amino group of different amine numbers respectively, the entire resin (A) component having an amine number of 1.5 to 10.0, a compound (B) component that generates an amine by means of moisture and/or light, a thickener (C) component, and a diluent (D) component.

2. The resist composition for pattern printing according to claim 1, wherein the (A) component comprises at least two selected from the group consisting of an amino group-containing acrylic resin and polyethyleneimine.

3. The resist composition for pattern printing according to claim 1 or 2, wherein the (A) component comprises a water-soluble resin and a water-insoluble resin.

4. The resist composition for pattern printing according to any one of claims 1 to 3, wherein a content of the (A) component is 10 parts by mass or more and 50 parts by mass or less with respect to 100 parts by mass of the resist composition for pattern printing.

5. The resist composition for pattern printing according to any one of claims 1 to 4, wherein the (B) component is at least one selected from the group consisting of a compound having a ketimine structure and a photobase generator, and a content of the (B) component is 0.1 parts by mass or more and 10 parts by mass or less with respect to 100 parts by mass of the resist composition for pattern printing.

6. The resist composition for pattern printing according to any one of claims 1 to 5, wherein the (C) component is at least one selected from the group consisting of fumed silica, clay, bentonite and talc, and a content of the (C) component is 0.01 parts by mass or more and 5 parts by mass or less with respect to 100 parts by mass of the resist composition for pattern printing.

7. The resist composition for pattern printing according to any one of claims 1 to 6, wherein the (D) component is ethylene glycol monoethyl ether.

8. A method for forming a circuit pattern, comprising etching an amorphous silicon layer with an aqueous alkaline solution using the resist composition for pattern printing according to any one of claims 1 to 7.

9. A method for forming a circuit pattern, comprising, after etching a base layer with an aqueous alkaline solution using the resist composition for pattern printing according to any one of claims 1 to 7, peeling off a resist using an aqueous acid solution and/or an alcohol-containing aqueous solution.

10. A method for producing a solar battery, comprising a circuit pattern forming step of forming a circuit pattern on a solar battery amorphous layer according to the method for forming a circuit pattern according to claim 8 or 9.

11. A solar battery which is produced by the method for producing a solar battery according to claim 10.

## INTERNATIONAL SEARCH REPORT

| International application No. |
| --- |
| PCT/JP2019/022491 |

**A. CLASSIFICATION OF SUBJECT MATTER**
Int.Cl. H05K3/06(2006.01)i, H01B13/00(2006.01)i, H01L21/312(2006.01)i, H01L31/0224(2006.01)i, H01L31/0445(2014.01)i
According to International Patent Classification (IPC) or to both national classification and IPC

**B. FIELDS SEARCHED**

Minimum documentation searched (classification system followed by classification symbols)
Int.Cl. H05K3/06, H01B13/00, H01L21/312, H01L31/0224, H01L31/0445

| Documentation searched other than minimum documentation to the extent that such documents are included in the fields searched | |
| --- | --- |
| Published examined utility model applications of Japan | 1922–1996 |
| Published unexamined utility model applications of Japan | 1971–2019 |
| Registered utility model specifications of Japan | 1996–2019 |
| Published registered utility model applications of Japan | 1994–2019 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 10-064333 A (TAIYO INK MFG. CO., LTD.) 06 March 1998, paragraph [0008] (Family: none) | 1-11 |
| A | JP 2001-133982 A (KANSAI PAINT CO., LTD.) 18 May 2001, paragraph [0008] (Family: none) | 1-11 |
| A | WO 2009/099065 A1 (SONY CHEMICAL & INFORMATION DEVICE CORP.) 13 August 2009, paragraph [0035] & CN 102017821 A & KR 10-2010-0119759 A | 1-11 |
| A | JP 07-261385 A (AJINOMOTO CO., INC.) 13 October 1995, paragraphs [0026], [0027] (Family: none) | 1-11 |

☐ Further documents are listed in the continuation of Box C.  ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 19 August 2019 (19.08.2019) | 27 August 2019 (27.08.2019) |

| Name and mailing address of the ISA/ | Authorized officer |
| --- | --- |
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**EP 3 806 593 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H02224295 A
- JP H0651516 A
- JP 3711198 B
- JP H7242737 B